# EUROPÄISCHE PATENTANMELDUNG

(11) **EP 1 770 786 A1**
(43) Veröffentlichungstag der Anmeldung: **04.04.2007**
(21) Anmeldenummer: 06020231.4
(22) Anmeldetag: 27.09.2006
(51) Int. Cl.: H01L 29/78, H01L 27/12, H01L 21/336, H01L 21/84, H01L 21/768, H01L 21/74, H01L 21/762, H01L 23/552, H01L 29/40, H01L 29/786

(54) **Halbleiteranordnung und Verfahren zur Herstellung einer Halbleiteranordnung**

(30) Priorität: 29.09.2005 DE 102005046624
(71) Anmelder: ATMEL Germany GmbH, 74072 Heilbronn (DE)
(72) Erfinder: Dudek, Volker, 76275 Ettlingen (DE); Schwantes, Stefan, 74080 Heilbronn (DE); Höhnemann, Holger, 74211 Leingarten (DE); Florian, Tobias, 70569 Stuttgart (DE); Dietz, Franz, 74257 Untereisesheim (DE)
(74) Vertreter: Müller, Wolf-Christian

(57) **Zusammenfassung**

Halbleiteranordnung und Verfahren zur Herstellung einer Halbleiteranordnung, wobei
- ein leitfähiges Substrat (100), ein Bauelementebereich (400) und eine den Bauelementebereich (400) von dem leitfähigen Substrat (100) isolierende Isolatorschicht (200) ausgebildet wird,
- ein Graben (700) in den Bauelementebereich (400) bis zur Isolatorschicht (200) geätzt wird,
- der Graben (700) weiter in die Isolatorschicht (200) bis zum leitfähigen Substrat (100) geätzt wird, und
- innerhalb des Grabens (700) das leitfähige Substrat (100) zur Ausbildung von voneinander isolierten leitfähigen Substratbereichen (141, 142, 143, 144, 145, 146) zumindest teilweise geätzt wird.

## Beschreibung

Die vorliegende Erfindung betrifft eine Halbleiteranordnung, eine Verwendung, einen Schaltkreis und ein Verfahren zur Herstellung einer Halbleiteranordnung.

Aus der DE 102 60 616 B3 ist ein Verfahren zum Herstellen eines Halbleiterbauelements bekannt. Dabei wird eine Bauelementstruktur auf einem Wafer gebildet, wobei der Wafer ein rückseitiges Halbleitersubstrat, eine vergrabene Isolatorschicht und eine oben liegende Halbleiterschicht umfasst. Eine Ätzstoppschicht wird auf dem Wafer gebildet. Der Wafer trägt die Bauelementstruktur. Ein Fenster wird in der Ätzstoppschicht ausgebildet. Eine dielektrische Schicht wird auf der Ätzstoppschicht ausgebildet, die das darin gebildete Fenster aufweist. Danach erfolgt ein simultanes Ätzen eines ersten Kontaktloches durch die dielektrische Schicht und das Fenster bis hinunter zu dem rückseitigen Halbleitersubstrat und wenigstens eines zweiten Kontaktloches durch die dielektrische Schicht bis hinunter zu der Bauelementstruktur.

Bei der Herstellung von Halbleiterbauelementen werden SOI-Wafer oder SOI-Substrate verwendet, um eine höhere Isolation zwischen benachbarten Bauelementen in einem integriertem Schaltkreis verglichen mit Bauelementen bereitzustellen, die in Bulk-Wafer ausgebildet worden sind. SOI-Substrate sind Silizium-Wafer mit einer dünnen Schicht aus einem Oxid oder aus anderen Isolatoren, die darin vergraben ist. Bauelemente werden innerhalb einer dünnen Siliziumschicht oberhalb des vergrabenen Oxids hergestellt. Die erhöhte Isolation, die dadurch erzielt wird, kann den "Latch-Up" in CMOS-Bauelementen (CMOS: Complementary Metal Oxide Semiconductor) eliminieren und reduziert weiterhin parasitäre Kapazitäten. Zusätzlich zu der vergrabenen Oxidschicht wird häufig STI (Shallow Trench Isolation) verwendet, um Transistoren oder andere Bauelemente lateral voneinander vollständig zu isolieren.

Da das rückwärtige Siliziumsubstrat von den Bauelementen mittels des vergrabenen Oxids vollständig entkoppelt ist, tendiert das Potential des Rückseitensubstrats zum Floaten während des Betriebs des Schaltkreises. Dies kann elektrische Eigenschaften des Schaltkreises beeinflussen und die Betriebszuverlässigkeit reduzieren.

Um zu verhindern, dass das rückwärtige Siliziumsubstrat des Bauelementes floatet, werden spezielle Kontakte gebildet, um das Rückseitensubstrat mit einer Metallschicht zu verbinden, die ein definiertes Potential aufweist. Zunächst wird von einer SOI-Struktur ausgegangen, die ein rückwärtiges Siliziumsubstrat, eine vergrabene Oxidschicht und eine oben liegende Siliziumschicht umfasst. Transistorstrukturen sind über der SOI-Struktur gebildet. Die oben liegende Siliziumschicht weist geätzte mit STI-Material gefüllte Isolationsgräben auf, um die Transistorstrukturen voneinander und von weiteren Bauelementen zu entkoppeln.

Über der oben liegenden Siliziumschicht, dem STI-Material der Isolationsgräben und den Transistorstrukturen ist beispielsweise eine Siliziumoxinitridschicht (SiON) abgeschieden, die in nachfolgenden Ätzprozessen als Stoppschicht verwendet wird. Ferner können zwischen dieser Ätzstoppschicht und der oben liegenden Siliziumschicht Silizide gebildet sein.

Ferner ist eine TEOS-Schicht (TEOS: Tetraethylorthosilikat) als Maskierungsschicht abgeschieden. Nachdem die Transistorstrukturen und der Kontaktstapel aus Siliziumoxinitrid (SiON) und Tetraethylorthosilikat (TEOS) gebildet worden sind, wird dann eine Fotolackschicht strukturiert, um eine Rückseitenkontaktmaske mit einer Öffnung zum Ätzen eines Kontaktes des rückwärtigen Siliziumsubstrats bereitzustellen.

Ist das Rückseitenkontaktmaskenstrukturmuster in der Fotolackschicht einmal definiert, wird der Stapel aus Tetraethylorthosilikat (TEOS), Siliziumoxinitrid (SiON), STI-Material und vergrabenem Oxid bis auf das rückwärtige Siliziumsubstrat heruntergeätzt. Durch diesen Ätzvorgang wird ein Kontaktloch gebildet. Das STI-Material des Isolationsgrabens ist durch die Bildung des Kontaktloches geteilt worden. Der Fotolack wird nun durch einen Plasmastrip und einen zusätzlichen nasschemischen Reinigungsschritt entfernt.

Ist das rückwärtige Kontaktloch einmal gebildet, findet die Bildung der Kontakte zum Verbinden der Transistorstrukturen statt. Dies wird einen anderen Fotolackschichtstrukturierungsprozess und einen getrennten Ätzschritt erfordern.

Der zuvor beschriebene Stand der Technik ist beispielsweise der DE 100 54 109 A1 entnehmbar. Ergänzend wird auf US 5,965,917 A hingewiesen, die sich ebenfalls mit der Problematik der Substratkontaktierung bei SOI-Strukturen befasst. Aus der US 2003/0094654 A1 sind zwei leitfähige, von einer vergrabenen Oxidschicht voneinander isolierte Substratschichten als Leitungsschienen bekannt, die jeweils durch einen tiefen Graben kontaktiert sind.

Aus der EP 1 120 835 A2 ist eine Durchkontaktierung durch eine vergrabene isolierende Schicht in ein Halbleiter-Substrat bekannt. Dabei verbindet die Durchkontaktierung die Sourceregion eines Feldeffekttransistors mit dem unterhalb der vergrabenen isolierenden Schicht ausgebildeten Halbleitersubstrat-Substrat. Auch aus der DE 103 03 643 B3 ist ein Verfahren zur Herstellung von Substratkontakten bei SOI-Schaltungsstrukturen bekannt. Dabei sind mehrere Schichtfolgen einander überdeckende Metallisierungsschichten im Bereich der Kontaktierung ausgebildet. Eine Kontaktierung eines Siliziumsubstrats in einem dotierten Gebiet mittels Polysilizium ist hingegen in der WO 02/073667 A2 offenbart.

Aus der US 6,372,562 B1 ist eine Kontaktierung eines Substratbereiches durch eine dielektrische Schicht hindurch bekannt, wobei der kontaktierte Substratbereich durch einen in Sperrrichtung gepolten PN-Übergang von einem weiteren Substratbereich isoliert ist. Ebenfalls in der GB 2 346 260 A wird ein Verfahren zur Erzeugung eines Kontakts zu einem durch einen PN-Übergang isolierten Substratbereich in einem tiefen Graben eines SOI-Bauteils offenbart. Aus der EP 0 635 884 A1 ist ein Verfahren zur Herstellung eines Grabens in einem Substrat und dessen Verwendung in der Smart-Power-Technologie bekannt. Dabei wird nach Verstärkung einer Grabenmaske durch eine nicht konform abgeschiedene Schutzschicht in einer zweiten Grabenätzung die vergrabene isolierende Schicht bis auf das Siliziumsubstrat durchgeätzt. Ein weiteres Verfahren zur Herstellung einer Substratkontaktierung ist aus der US 6,632,710 B2 bekannt.

Der Erfindung liegt eine erste Aufgabe zu Grunde ein Verfahren zur Herstellung einer Kontaktierung eines Substrats mit einer möglichst erhöhten Prozesssicherheit weiter zu entwickeln.

Diese Aufgabe wird durch das Verfahren mit den Merkmalen des Patentanspruchs 1 gelöst. Vorteilhafte Weiterbildungsvarianten sind Gegenstand von abhängigen Ansprüchen.

Demgemäß ist ein Verfahren zur Herstellung einer Halbleiteranordnung vorgesehen. Das Verfahren weist mehrere Prozessschritte auf. Dabei werden ein leitfähiges Substrat, ein Bauelementebereich und eine den Bauelementebereich von dem leitfähigen Substrat isolierende Isolatorschicht ausgebildet. Ein derartiger Aufbau wird auch als SOI-Struktur (engl. Silicon-On-Insulator) bezeichnet. Zur Herstellung einer derartigen SOI-Struktur wird vorzugsweise ein erster Wafer mit dem Bauelementebereich und der Isolatorschicht auf einen zweiten Wafer mit dem leitfähigen Substrat gebondet, so dass bezüglich der Waferoberfläche der Bauelemente zuoberst auf der Isolatorschicht angrenzend und die Isolatorschicht oberhalb des leitfähigen Substrats angrenzend ausgebildet ist. Der Bauelementebereich weist vorzugsweise einen monokristallinen Halbleiter zur Ausbildung von Halbleiterbauelementen auf. Ein geeignetes Halbleitermaterial ist beispielsweise Silizium, Germanium oder Mischkristalle, wie GalliumArsenid.

In einem weiteren Verfahrensschritt wird ein Graben in den Bauelementebereich bis zur Isolatorschicht im Wesentlichen in vertikaler Richtung geätzt. Zur Ätzung kann beispielsweise reaktives lonenätzen (ICP Inductive Coupled Plasma) verwendet werden. Vorzugsweise ist die Ätzung dabei selektiv zum Halbleitermaterial des Bauelementebereichs. Diese Ätzung stoppt dabei an der Grenzfläche zur Isolatorschicht. Vorzugsweise weist der Graben ein hohes Aspektverhältnis von Tiefe zu Breite auf.

In einem späteren Verfahrensschritt wird der Graben weiter in die Isolatorschicht bis zum leitfähigen Substrat geätzt. Vorzugsweise ist die Ätzung dabei selektiv zum Dielektrikum der Isolatorschicht. Diese Ätzung stoppt dabei an der Grenzfläche zum leitfähigen Substrat.

Erfindungsgemäß ist vorgesehen, dass das leitfähige Substrat zur Ausbildung von voneinander isolierten leitfähigen Substratbereichen teilweise geätzt wird. Die Ätzung des leitfähigen Substrats bewirkt eine Strukturierung mit voneinander getrennten Substratbereichen. Zwar ist es prinzipiell möglich diese Trennung als Isolation zu nutzen, bevorzugt ist jedoch vorgesehen, dass ein Dielektrikum zur Isolation ausgebildet wird. Die Strukturierung in voneinander getrennte, leitfähige Substratbereiche erfolgt somit nach dem Bonden der Wafer. Vorzugsweise wird vor der Ätzung des leitfähigen Substrats ein Oxid, das den Boden des Grabens bedeckt, entfernt.

In einer bevorzugten und besonders vorteilhaften Weiterbildung ist vorgesehen, dass das leitfähige Substrat zumindest teilweise innerhalb des Grabens geätzt wird, um die voneinander isolierten Substratbereiche auszubilden. Die Ätzung erfolgt daher von derselben Waferseite, wie die Ätzung des Grabens, innerhalb einer durch den Graben gebildeten Öffnung. Die Ätzung ist dabei vorzugsweise selektiv zum zu ätzenden Material des leitfähigen Substrats. Dieses zu ätzende Material wird vorzugsweise als leitfähige Schicht des Substrats ausgebildet.

Gemäß einer vorteilhaften Weiterbildungsvariante wird zur Ausbildung der Isolierung der Substratbereiche zunächst eine leitfähige Schicht des Substrats durch die Ätzung strukturiert. In einem späteren Verfahrensschritt wird in dieser Weiterbildungsvariante ein offen liegender Bereich der leitfähigen Schicht zur Ausbildung eines isolierenden Dielektrikums thermisch oxidiert. Vorzugsweise weist die leitfähige Schicht zur thermischen Oxidation daher Silizium auf.

In einer anderen vorteilhaften Weiterbildung ist vorgesehen, dass zur Strukturierung eine Maskierung ausgebildet wird, die einen ersten Bereich der leitfähigen Schicht innerhalb des Grabens vor dem Ätzangriff schützt. Hingegen wird ein zweiter, nicht von der Maskierung geschützter Bereich der leitfähigen Schicht durch die Ätzung entfernt. Nach dem Entfernen der Maskierung verbleibt also ein Teil eines leitfähigen Substratbereiches innerhalb des Grabens. Zur Maskierung kann beispielsweise ein photolithographisch strukturierter Photolack verwendet werden.

Alternativ oder in Kombination zur thermischen Oxidation des offen liegenden Bereiches der leitfähigen Schicht wird gemäß einer Weiterbildungsvariante innerhalb des Grabens zwischen den ausgebildeten Substratbereichen ein Dielektrikum abgeschieden. Dieses Dielektrikum ist beispielsweise Siliziumnitrid oder vorzugsweise Siliziumdioxid. Zur Ausbildung der Isolierung der Substratbereiche wird zuvor eine leitfähige Schicht des Substrats innerhalb des Grabens zumindest teilweise durch die Ätzung entfernt, so dass sich als Zwischenraum ein Trenngraben zwischen den leitfähigen Substratbereichen bildet. Vorzugsweise ist vorgesehen, dass mit derselben Verfüllung des Zwischenraums zwischen den leitfähigen Substratbereichen zugleich auch der Graben zumindest teilweise mit dem Dielektrikum verfüllt wird.

Gemäß einer Weiterbildungsvariante ist vorgesehen, dass vorzugsweise nach den Ätzschritten ein elektrischer Leiter in den durch das Isolationsmaterial gegenüber dem Halbleitermaterial des Bauelementebereiches isolierten Graben oder in einen weiteren Graben eingebracht und mit einem Substratbereich der voneinander isolierten Substratbereiche leitend verbunden wird.

Vorteilhafterweise ist vorgesehen, dass das Substrat mit einer Dielektrikumschicht und mit einer leitfähigen Schicht ausgebildet wird. Hierzu wird beispielsweise dotiertes, insbesondere polykristallines Silizium auf einen Siliziumdioxidwafer aufgebracht. Auch ist es möglich einen einkristallinen Siliziumwafer mit einem Siliziumdioxidwafer zu bonden und die Dicke der einkristallinen Siliziumschicht auf wenige µm Dicke zu schleifen.

In einem Verfahrensschritt einer vorteilhaften Weiterbildungsvariante wird eine flache Vertiefung in eine Oberfläche des Bauelementebereiches geätzt. Die Ätzung erfolgt vorzugsweise mit einem kleinen Aspektverhältnis von Tiefe zu Breite der geätzten Vertiefung (STI). In einem späteren Verfahrensschritt wird innerhalb der flachen Vertiefung der Graben in den Bauelementebereich bis zur Isolatorschicht durch das Halbleitermaterial des Bauelementebereichs geätzt. Die Ätzung erfolgt dabei vorzugsweise selektiv gegenüber Oxidschichten. Weiterhin wird für die Ätzung des Grabens vorzugsweise eine Ätzung verwendet, die ein hohes Aspektverhältnis von Tiefe zu Breite der Ätzung ermöglicht (Deep Trench).

Anschließend werden die Wände des Grabens mit einem Isolationsmaterial ausgebildet. Zur Ausbildung des Isolationsmaterials kann auf die Wandbereiche des Grabens beispielsweise ein Oxid abgeschieden werden. Bevorzugt wird zur Ausbildung des Isolationsmaterials jedoch ein an den Graben angrenzendes Siliziummaterial des Bauelementebereichs oxidiert. Vorzugsweise grenzt das Isolationsmaterial dabei an die vergrabene Isolatorschicht.

Gemäß einer bevorzugten Weiterbildung der Erfindung ist vorgesehen, dass die flache Vertiefung mit Dielektrikum gefüllt wird. Nach dem Verfüllen mit Dielektrikum wird ein Dotierstoff - beispielsweise Bor - für ein Halbleitergebiet des zumindest einen Bauelementes eingebracht. Zur Einbringung kann der Dotierstoff beispielsweise eindiffundiert und/oder implantiert werden. Das Dielektrikum in der flachen Vertiefung dient dabei als Maskierung, um das Halbleitergebiet des zumindest einen Bauelementes selbstjustiert zur Vertiefung in dem Bauelementebereich auszubilden. Zur Selbstjustierung weist das Dielektrikum beispielsweise eine derartige Dicke auf, dass beim Einbringen des Dotierstoffes dieser ausschließlich neben dem Dielektrikum in den Bauelementebereich eingebracht wird. Hingegen erfolgt im Wesentlichen kein Einbringen des Dotierstoffes in einem Bereich in der Nähe des tiefen Grabens unterhalb des Dielektrikums in der flachen Vertiefung. Ein Halbleitergebiet, das durch den eingebrachten Dotierstoff gebildet wird und dem zumindest einen Bauelement im Bauelementebereich zugeordnet ist, ist damit neben der flachen Vertiefung positioniert. Hierzu ist keine zusätzliche Maskenkante notwendig, so dass dies als Selbstjustierung bezeichnet werden kann.

In einer vorteilhaften Weiterbildung der Erfindung ist vorgesehen, dass eine Menge von Bauelementen in dem Bauelementebereich nach der Ausbildung von Isolationsmaterial zur Isolierung der Grabenwände ausgebildet wird. Das thermische Budget zur Ausbildung der Bauelemente im Bauelementebereich kann daher unabhängig von der Ausbildung des tiefen Graben erfolgen. Wird in den tiefen Graben ein Leiter aus Polysilizium eingebracht, kann dies vorteilhafterweise ebenfalls vor der Ausbildung der Halbleiterbauelemente erfolgen. Die Menge der Bauelemente ist dabei gegenüber einem oder mehreren Substratbereichen in vertikaler Richtung durch die vergrabene Isolatorschicht isoliert. Weiterhin ermöglicht das Isolatormaterial in den tiefen Gräben und Isolationsmaterial in der flachen Vertiefung eine laterale Isolation von zumindest zwei Bauelementen. Die Erfindung bevorzugt weiterbildend wird zeitgleich zum Ätzen des Grabens zur Aufnahme des Leiters ein Isoliergraben geätzt, wobei der Isoliergraben mit einem Isolator vollständig verfüllt wird und ausschließlich der Isolation eines Bauelementes dient.

Eine andere Variante sieht vor, dass das leitfähige Substrat zur Ausbildung von voneinander isolierten leitfähigen Substratbereichen von der dem Graben abgewandten Substratseite aus geätzt wird. Diese Ätzung kann auch nachträglich nach Ausbildung des Bauelementes erfolgen. Zur Kontaktierung eines Substratbereiches von der Seite des Bauelementes aus wird ein elektrischer Leiter in den Graben eingebracht und mit zumindest einem Substratbereich der leitfähigen Substratbereiche leitend verbunden. Dabei werden Wände des Grabens mit einem Isolationsmaterial ausgebildet.

Eine zweite, der Erfindung zu Grunde liegende Aufgabe ist es eine Halbleiteranordnung anzugeben. Diese Aufgabe durch die Halbleiteranordnung mit den Merkmalen des Patentanspruchs 12 gelöst. Vorteilhafte Weiterbildungsvarianten sind Gegenstand von abhängigen Ansprüchen.

Demzufolge ist eine Halbleiteranordnung vorgesehen. Diese Halbleiteranordnung weist einen Bauelementebereich, ein leitfähiges Substrat und eine vergrabene Isolatorschicht auf, wobei die Isolatorschicht den Bauelementebereich gegenüber dem leitfähigen Substrat isoliert. Bezogen auf die Waferoberfläche ist dabei bevorzugt die vergrabene Isolatorschicht oberhalb des Substrats und der Bauelementebereich oberhalb der vergrabenen Isolatorschicht jeweils angrenzend aufgebracht. Eine derartige Anordnung mit einer vergrabenen Isolatorschicht, wird bei der Verwendung von Silizium als Halbleitermaterial auch als SOI (Silicon On Isolator) bezeichnet. Die vergrabene Isolatorschicht kann beispielsweise Siliziumdioxid aufweisen.

Die Halbleiteranordnung weist zumindest einen, mit einem Isolationsmaterial gefüllten Graben auf. Dieser Graben isoliert zumindest ein Bauelement im Bauelementebereich von weiteren Bauelementen im Bauelementebereich. Im Bauelementebereich werden die Bauelemente, wie Feldeffekttransistoren, ausgebildet. Hierzu ist der Bauelementebereich aus einkristallinem Halbleitermaterial, vorteilhafterweise aus Silizium mit vorzugsweise einer <100> Kristallorientierung ausgebildet.

Ein elektrischer Leiter ist mit dem leitfähigen Substrat leitend verbunden. Der elektrische Leiter ist durch das den Graben füllende Isolationsmaterial isoliert und innerhalb des Grabens angeordnet. Der Graben ist dabei bis zu einer Oberfläche ausgebildet. Demzufolge grenzt der Graben an den Bauelementebereich an.

Das Substrat weist leitfähige Substratbereiche auf, die durch geätzte Trenngräben unterteilt sind. In den Trenngräben ist ein Dielektrikum ausgebildet, das die Substratbereiche voneinander isoliert. Vorzugsweise sind die Substratbereiche in einer Schicht ausgebildet und dabei lediglich lateral voneinander beabstandet. Um die Leitfähigkeit zu bewirken weisen die Substratbereiche vorzugsweise dotiertes Halbleitermaterial, wie beispielsweise Silizium oder Mischkristalle wie Siliziumgermanium oder Siliziumkarbid auf. Das dotierte Halbleitermaterial kann dabei einkristallin oder amorph, vorzugsweise jedoch polykristallin ausgebildet sein. Der Leitungstyp der Dotanden ist vorteilhafterweise an den Leitungstyp des kontaktierenden Halbleitermaterials angepasst. Auch können für verschiedene Substratbereiche verschiedene Leitungstypen vorgesehen sein.

Das leitfähige Substrat weist daher eine Anzahl von voneinander isolierten Substratbereichen auf. Diese Substratbereiche können beispielsweise durch eine tiefe Grabenätzung für die Trenngräben voneinander getrennt werden. Vorzugsweise werden diese tiefen Trenngräben dann mit einem Dielektrikum verfüllt. Jeder Substratbereich kann dabei unabhängig voneinander an ein separates, festes oder variables Potential angelegt werden, so dass getrennte Bauelemente im Bauelementebereich mit unterschiedlichen, angelegten Substratpotentialen betrieben werden können.

Die Kontaktierung des leitfähigen Substrats kann dabei unterschiedlichen Funktionen dienen. Eine wichtige Funktion ist es, die Bauelementeparameter von auf der gegenüberliegenden Seite der vergrabenen Isolatorschicht angeordneten Bauelementen durch die Höhe oder den zeitlichen Verlauf des angelegten Substratpotentials zu verändern. Insbesondere kann die Durchbruchsspannung eines lateralen N-DMOS-Transistors oder eines P-DMOS-Transistors verbessert werden. Weiterhin kann durch die Höhe eines angelegten Substratpotentials eine Stromverstärkung eines NPN-Bipolartransistors verändert, insbesondere vergrößert werden. Dabei ist eine deutliche Verbesserung für positive Substratpotentiale zu erreichen. Weiterhin kann das Substrat zudem als Leitungsverbindung zu einem anderen Bauelement oder zu einem auf der Rückseite angeordneten Kontakt der integrierten Schaltung genutzt werden. Ebenso ist es möglich durch ein Einbringen von Dotanden in das Substrat, Halbleiterbauelemente, wie beispielsweise Dioden im Substrat auszubilden.

Gemäß einer vorteilhaften Weiterbildungsvariante ist vorgesehen, dass mehrere voneinander isolierte Substratbereiche jeweils mit zumindest einem in je einem Graben angeordneten Leiter leitend verbunden sind. Diese Weiterbildungsvariante wird bevorzugt für Bauelemente verwendet, deren elektrische Eigenschaften durch eine, durch den jeweils unter dem Bauelement ausgebildeten Substratbereich gebildete Elektrode beeinflussbar sind. So kann mittels eines derart angeschlossenen ersten Substratbereichs unterhalb eines N-LDMOS-Feldeffekttransistors dieser durch Anlegen eines Potentials in seinen elektrischen Eigenschaften gesteuert werden. Hingegen kann ein P-LDMOS-Feldeffekttransistor mit einem zweiten Substratbereich, der von dem ersten Substratbereich isoliert und separat angeschlossen ist unabhängig durch ein weiteres Potential in seinen elektrischen Eigenschaften gesteuert werden. Zusätzlich kann auch ein nicht kontaktierter Substratbereich vorgesehen sein.

In einer anderen vorteilhaften Weiterbildungsvariante ist zumindest einer der Substratbereiche unterhalb des Bauelementes ausgebildet. Vorzugsweise ist das Bauelement ein lateraler DMOS-Feldeffekttransistor.

Gemäß einer wiederum anderen Weiterbildungsvariante ist vorgesehen, dass der Leiter und ein Substratbereich der Substratbereiche das zumindest eine Bauelement oder einen Schaltkreis mit dem zumindest einen Bauelement zumindest teilweise umgeben und zusammen als Schirmung ausgebildet sind. Vorzugsweise ist das zumindest eine Bauelement oder der Schaltkreis bis auf die Anschlüsse allseitig zusätzlich durch Dielektrikum isoliert, wobei die Schirmung das isolierende Dielektrikum vorzugsweise umgibt.

In einer vorteilhaften Weiterbildungsvariante ist vorgesehen, dass innerhalb des Grabens ein Dielektrikum eingebracht ist. Dieses Dielektrikum ist in einen durch einen Trenngraben gebildeten Zwischenraum zwischen den Substratbereichen eingebracht und isoliert die Substratbereiche voneinander. Zum Einbringen des Dielektrikums kann dieses beispielsweise gesputtert oder mittels CVD abgeschieden werden.

Gemäß einer vorteilhaften Weiterbildungsvariante ist der Graben innerhalb einer Vertiefung in der Oberfläche ausgebildet. Die Vertiefung in der Oberfläche ist vorzugsweise flacher als die Tiefe des Grabens. Weiterhin vorzugsweise ist die Vertiefung in der Oberfläche breiter als die Breite des Grabens. Besonders bevorzugt weist die Vertiefung in der Oberfläche ein kleineres Aspektverhältnis als der Graben auf. Das Aspektverhältnis ist dabei das Verhältnis der Tiefe des Grabens oder der Vertiefung zu seiner/ihrer Breite. Die Oberfläche ist vorzugsweise die dem Substrat abgewandte Oberfläche des Bauelementebereichs der Halbleiteranordnung.

Gemäß einer bevorzugten Ausgestaltungsvariante ist vorgesehen, dass der Graben nicht in einem Randbereich der Vertiefung, sondern in einem Mittenbereich, vorzugsweise in der Mitte der Vertiefung ausgebildet ist. Zwar besteht die Möglichkeit die Vertiefung in der Oberfläche durch eine lokale Oxidation (LOCOS; LOCaI Oxidation of Silicon) herzustellen, bevorzugt werden jedoch kleine Strukturen erzeugt. Hierzu ist in einer Weiterbildung der Erfindung vorgesehen, dass als Vertiefung ein flacher Graben vorgesehen ist. Dieser flache Graben ist vorzugsweise mit Dielektrikum verfüllt. Dies wird auch als STI (Shallow Trench Isolation) bezeichnet. Innerhalb dieses flachen Grabens (STI) ist der tiefe Graben (Deep Trench Isolation) mit einem höheren Aspektverhältnis ausgebildet. Bevorzugt sind beide Gräben im Halbleitermaterial des Bauelementebereichs geätzt.

Gemäß einer anderen vorteilhaften Weiterbildung ist ein Halbleitergebiet des zumindest einen Bauelementes selbst justiert zur Vertiefung in dem Bauelementebereich ausgebildet. Das Halbleitergebiet ist beispielsweise eine eindiffundierte Wanne mit einem Dotierstofftyp. Bevorzugt ist das Halbleitergebiet ein beispielsweise durch eine Implantation eines Dotierstoffs ausgebildetes Halbleiteranschlussgebiet. Durch die Selbstjustierung grenzt das Halbleitergebiet an die Vertiefung an.

Vorteilhafte Ausgestaltungen der Erfindung sehen vor, dass der elektrische Leiter ein hochdotiertes Halbleitermaterial und/oder ein Metall und/oder ein Silizid aufweist.

Ein weiterer Aspekt der Erfindung ist ein Schaltkreis mit einer zuvor beschriebenen Halbleiteranordnung. Dieser Schaltkreis weist vorzugsweise einen lateralen DMOS-Feldeffekttransistor auf. Der Schaltkreis weist Mittel auf, um an den elektrischen Leiter ein konstantes oder steuerbares Potential anzulegen. Dabei ist von dem konstanten oder steuerbaren Potential zumindest eine elektrische Eigenschaft des Bauelementes abhängig. Ein derartiges Mittel ist beispielsweise eine Verbindung mit einem Versorgungspotential oder ein angeschlossener Potentialschieber.

Ein anderer eigenständiger Aspekt der Erfindung ist eine Verwendung eines leitfähigen Substratbereiches und eines mit dem Substratbereich leitend verbundenen Leiters zur mehrseitigen Schirmung einer Anzahl von Bauelementen. Dabei ist zumindest ein Bauelement vorgesehen. Dieses ist oberhalb des leitfähigen Substratbereichs angeordnet und von dem Substratbereich dielektrisch isoliert. Dieser Aspekt der Erfindung kann mit zuvor erläuterten Weiterbildungsvarianten kombiniert werden.

Die zuvor beschriebenen Weiterbildungsvarianten, Ausgestaltungsvarianten und Aspekte der Erfindung sind sowohl einzeln als auch in Kombination besonders vorteilhaft. Dabei können sämtliche Weiterbildungsvarianten, Ausgestaltungsvarianten und Aspekte der Erfindung untereinander kombiniert werden. Mögliche Kombinationen sind in der Beschreibung der Ausführungsbeispiele zu den Figuren erläutert. Diese dort dargestellten Kombinationsmöglichkeiten der Weiterbildungsvarianten, Ausgestaltungsvarianten und Aspekte der Erfindung sind jedoch nicht abschließend.

Im Folgenden wird die Erfindung in Ausführungsbeispielen anhand von Zeichnungen mit den Figuren 1 bis 17 näher erläutert.

Dabei zeigen
- Fig. 1 bis Fig. 8: schematische Schnittansichten durch einen Wafer zu unterschiedlichen Prozesszeitpunkten der Herstellung einer Halbleiteranordnung eines ersten Ausführungsbeispiels;
- Fig.9: eine schematische Schnittansicht eines LDMOS-Feldeffekttransistors des ersten Ausführungsbeispiels mit einer Verbindung zum Substrat;
- Fig. 10 und Fig. 11: schematische Detailschnittansichten eines weiteren Ausführungsbeispiels zu unterschiedlichen Prozesszeitpunkten;
- Fig. 12: eine schematische Detailschnittansicht eines mit polykristallinem Silizium gefüllten Grabens zu einem Prozesszeitpunkt;
- Fig. 13: eine schematische Detailschnittansicht eines mit Siliziumdioxid gefüllten Grabens zu einem Prozesszeitpunkt;
- Fig. 14 bis Fig. 16: schematische Detailschnittansichten eines weiteren Ausführungsbeispiels zu unterschiedlichen Prozesszeitpunkten; und
- Fig. 17: eine schematische Schnittansicht einer Halbleiteranordnung mit einem LDMOS-Feldeffekttransistor

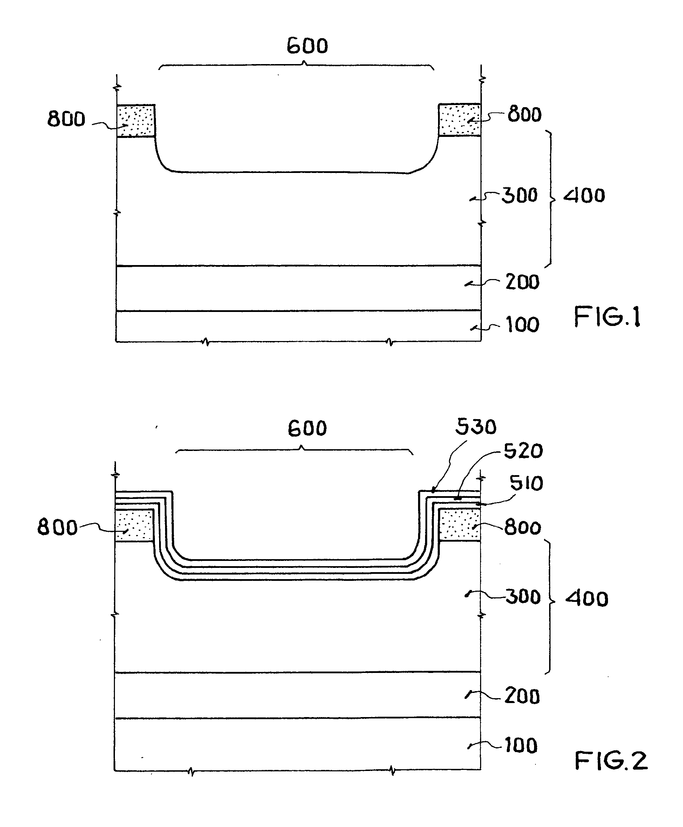

In den Figuren 1 bis 17 sind schematische Schnittansichten durch Wafer zu unterschiedlichen Prozesszeitpunkten der Herstellung einer Halbleiteranordnung dargestellt. Gleiche Strukturelemente sind in der Regel mit gleichen Bezugszeichen versehen. Im Folgenden sind dabei für eine leichtere Verständlichkeit nur die wichtigsten Verfahrensschritte erläutert. Dabei sind weitere in der Halbleiterherstellung übliche und dem Fachmann an sich bekannte Prozessschritte, wie Abscheidungen, Reinigungsschritte und Planarisierungen nicht näher erläutert. Diese können genutzt werden um das Verfahren in einen Gesamtherstellungsprozess zu integrieren.

In Fig. 1 ist ein Bauelementebereich 400 aus einem Halbleitermaterial, in diesem Fall aus Silizium 300, ein leitfähiges, n-dotiertes Siliziumsubstrat 100 und eine vergrabene Isolatorschicht 200 dargestellt. Die Isolatorschicht 200 isoliert den Bauelementebereich 400 von dem Siliziumsubstrat 100. Die Isolatorschicht 200 ist ein Dielektrikum beispielsweise aus Siliziumdioxid (SiO₂). Auf das Silizium 300 des Bauelementebereichs 400 ist zur Maskierung eine Hartmaske 800 aus Siliziumnitrid (Si₃N₄) aufgebracht. Eine Vertiefung 600 in Form eines flachen Grabens 600 (STI) ist in die Oberfläche des Bauelementebereichs 400 aus Silizium 300 geätzt, wobei Bereiche zur Ausbildung von Bauelementen durch die Hartmaske 800 vor dem Ätzangriff geschützt sind.

In Fig. 2 ist innerhalb des geätzten flachen Grabens 600 und auf der Hartmaske 800 eine Schichtenfolge aus einer ersten Siliziumdioxidschicht 510 (SiO₂), einer Schicht aus polykristallinem Silizium 520 (Poly-Si) und einer zweiten Siliziumdioxidschicht 530 (SiO₂) aufgebracht. Diese Schichtenfolge 510, 520, 530 wird auch als OPO-Schicht bezeichnet. Vorzugsweise werden diese Schichten 510, 520, 530 nacheinander, aufeinander folgend abgeschieden.

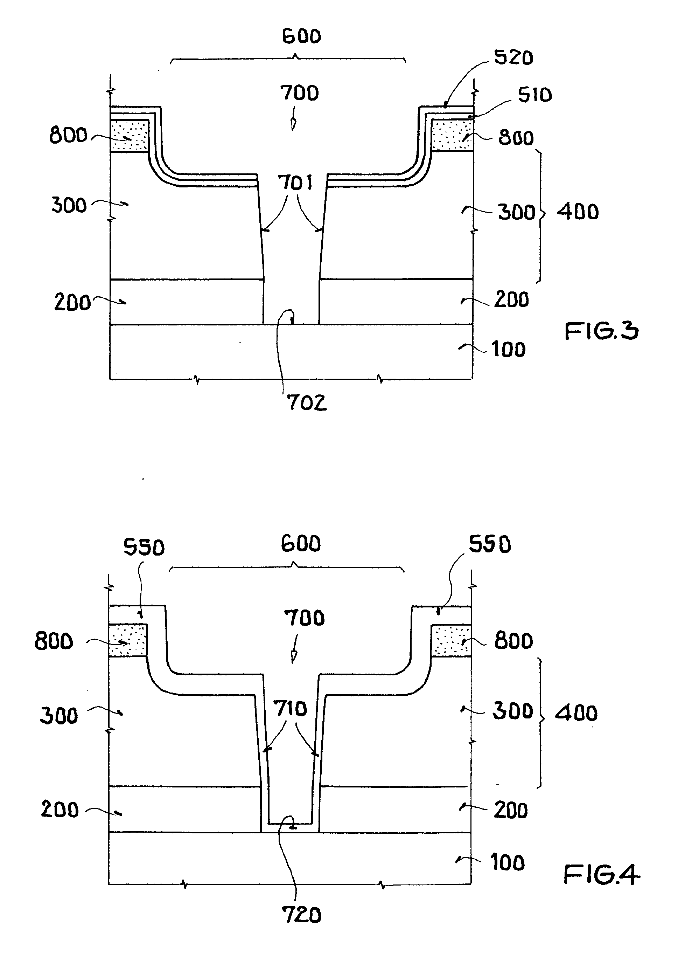

Die Schichtenfolge aus den Schichten 510, 520, 530 wird mittels eines Photolacks und einer Maske lithographisch derart strukturiert, dass eine vertikale Öffnung in die Schichtenfolge eingebracht wird. Durch diese vertikale Öffnung wird ein tiefer Graben 700 (engl. Deep Trench) geätzt. Diese Ätzung ist selektiv gegenüber der zweiten Oxidschicht 530 und trägt dabei im Wesentlichen nur das Silizium 300 ab. Hiernach wird das vergrabene Oxid 200 unterhalb der geätzten Öffnung entfernt. Zugleich wird auch die zweite Oxidschicht 530 mit entfernt. Fig. 3 zeigt den Zustand nach der Ätzung des vergrabenen Oxids 200 unterhalb der geätzten Öffnung und der zweiten Oxidschicht. Der tiefe Graben 700 weist Grabenwände 701 und einen Grabenboden 702 auf.

Nachfolgend wird im nächsten Prozessschritt ein thermisches Oxid in möglichst hoher Qualität, vorzugsweise mit einer Dicke von 50 nm hergestellt. Dabei wird an den Grabenwänden 701 und auf am Grabenboden 702 ein Oxidschicht 710 respektive 720 gebildet. Dieser Zustand ist in Fig. 4 schematisch dargestellt. Dabei wird Silizium-Material des Bauelementebereichs 400 im Wandungsbereich und Silizium-Material des Siliziumsubstrats 100 in Siliziumdioxid umgewandelt. Weiterhin wird die Polysiliziumschicht 520 ebenfalls in Siliziumdioxid umgewandelt, so dass zusammen mit der ersten Oxidschicht 510 eine dickere Siliziumdioxid-Deckschicht 550 zumindest innerhalb der flachen Vertiefung 600 auf dem Bauelementebereich 400 gebildet wird.

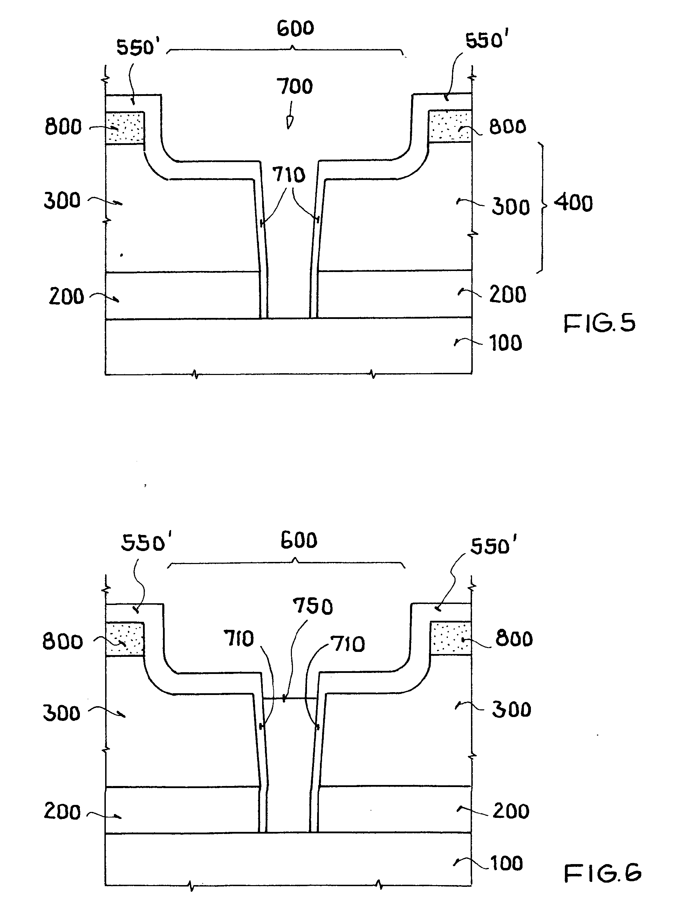

Im nächsten Prozessschritt wird mittels einer anisotropen Ätzung das Oxid 720 am Boden des tiefen Grabens 700 abgeätzt. Dieser Prozesszustand ist in Fig. 5 dargestellt. Dabei wird die Siliziumdioxid-Deckschicht 550' entsprechend gedünnt, jedoch nicht vollständig entfernt.

Anschließend wird konform Polysilizium 750 oder amorphes Silizium 750 auf dem Wafer abgeschieden und bis zum Eingang des tiefen Grabens 700 zurückgeätzt. Dieser Zustand ist in Fig. 6 dargestellt. Das Polysilizium 750 kann entweder bereits während der Abscheidung oder bei der späteren Kontaktöffnung durch Implantation dotiert werden. Der Dotierungstyp entspricht vorteilhafterweise dem des Siliziumsubstrats 100.

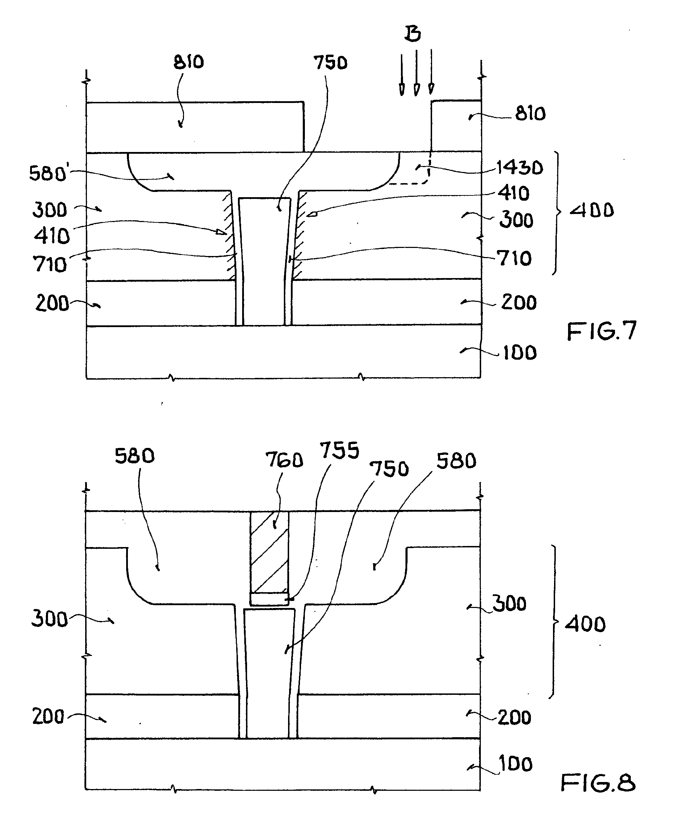

Nachfolgend wird zu Erzielung des Prozesszustands gemäß der Fig. 7 der flache Graben 600 mit Oxid 580' gefüllt, die Hartmaske (800) entfernt und die Waferoberfläche beispielsweise mittels chemisch-mechanischem Polierens (CMP) planarisiert. Die nächsten Verfahrensschritte dienen der Herstellung der Halbleiterbauelemente im Bauelementebereich 400. Dabei wird ein Resist 900 aufgebracht und als Implantationsmaske 900 photolithographisch strukturiert. Dabei bildet das Oxid 580' im flachen Graben 600 ebenfalls eine Maskierung, die das Halbleitermaterial 300 des Bauelementebereichs 400 im Bereich unterhalb des Oxids 580' vor dem zu implantierenden Dotierstoff schützt.

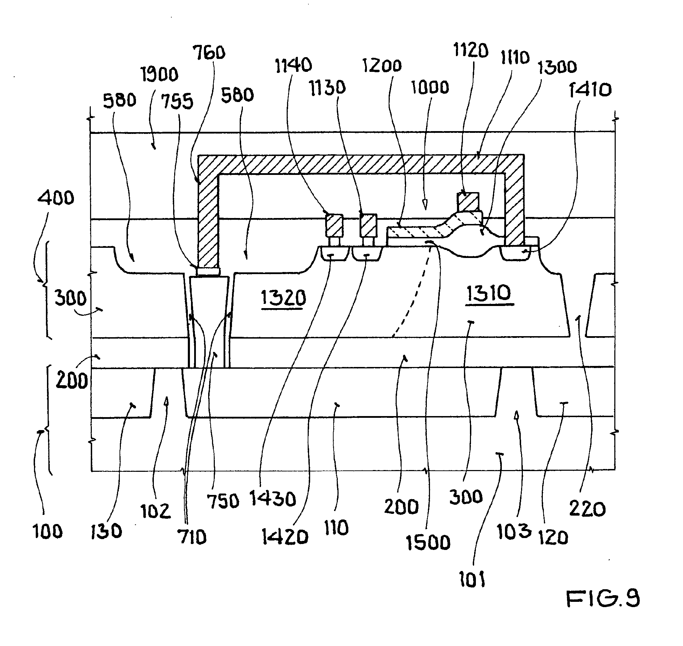

Die Maskierung durch das Oxid 580' bewirkt, dass ein Halbleitergebiet 1430 eines zugehörigen Bauelementes 1000 (siehe Fig. 9) an das Oxid 580' im flachen Graben 600 angrenzend ausgebildet wird. Das Halbleitergebiet 1430 wird dabei durch die Maskierung selbstjustierend zum flachen Graben 600 ausgerichtet. Im Ausführungsbeispiel der Fig. 7 wird Bor B als Dotierstoff implantiert, wobei das Halbleitergebiet 1430 beispielsweise als p-dotiertes Halbleiteranschlussgebiet mit einer hohen Dotierstoffkonzentration ausgebildet wird.

In einem Bereich des Bauelementebereichs 400, der an den flachen Graben 600 lateral angrenzt ist die Dichte der Kristallschäden im Bauelementebereich deutlich geringer als in einem Grenzbereich 410 des Bauelementebereichs 400, der lateral an den tiefen Graben 700 angrenzt. Der an das Oxid 710 angrenzende Grenzbereich 410 des Bauelementebereichs 400 kann eine hohe Dichte von Störungen im monokristallinen Kristallgitter aufweisen. Die Anordnung des tiefen Grabens innerhalb des flachen Grabens ermöglicht durch die Selbstjustierung des Halbleitergebietes 1430 und damit durch die Selbstjustierung des Bauelementes 1000 einen sichergestellten Abstand zwischen dem tiefen Graben und aktiven Gebieten des Bauelementes 1000, so dass Prozessstreuungen reduziert werden könnten. Als ein weiterer möglicher Vorteil der Ausbildung des tiefen Grabens 700 innerhalb des flachen Grabens 600 kann das Bauelement 1000 eine verbesserte Durchbruchspannung aufweisen. Vorteilhafterweise ist die Breite des flachen Grabens 600 an eine mögliche Dejustage der Maskierung zur Ätzung des tiefen Grabens 700 angepasst.

Die Kontaktierung des Siliziumsubstrats 100 durch den tiefen Graben 700 (Kontaktgraben) wird erst nach Fertigstellung aller Bauelemente weiter prozessiert. Zur Kontaktierung der Polysiliziumfüllung 750 wird das Oxid 580 im flachen Graben 600 in einem lithographisch maskierten Ätzschritt über dem Polysilizium 750 entfernt. Die geätzte Oxidöffnung wird nun mit einer Diffusionsbarriere 755, beispielsweise aus einem Silizid und mit einem Metall 760, beispielsweise Wolfram gefüllt. Dieser Prozesszustand ist in Fig. 8 dargestellt.

Die Fig. 9 zeigt eine schematische Schnittansicht durch einen Wafer mit einem Leistungsbauelement 1000, das im Bauelementebereich 400 aufgebildet ist, und eine Kontaktierung des Siliziumsubstrats 100. Das Siliziumsubstrat 100 ist dabei in mehrere leitfähige Substratbereiche 110, 120, 130 durch geätzte tiefe Trenngräben 102, 103 unterteilt. Zwischen den leitfähigen Substratbereichen 110, 120, 130 und unterhalb der leitfähigen Substratbereiche 110, 120, 130 ist ein Dielektrikum 101 beispielsweise aus Siliziumdioxid ausgebildet, das die Substratbereiche 110, 120, 130 voneinander und von der Rückseite des Wafers isoliert.

Die leitfähigen Substratbereiche 110, 120, 130 sind beispielsweise aus dotiertem polykristallinen Silizium, einem Silizid oder einem Metall ausgebildet. Ein Substratbereich 110 ist dabei unterhalb des Leistungsbauelementes 1000 ausgebildet. Das Leistungsbauelement 1000 ist durch den mit dem Polysilizium 750 gefüllten tiefen Graben (700) und durch zumindest eine weitere Grabenisolation 220 von benachbarten Bauelementen (in Fig. 9 nicht dargestellt) durch ein Dielektrikum 710, 220 insbesondere aus Siliziumdioxid isoliert.

Im Ausführungsbeispiel der Fig. 9 ist das Leistungsbauelement 1000 ein N-DMOS-Feldeffektransistor 1000. Dieser weist ein n-dotiertes Drainhalbleitergebiet 1410, eine N-Wanne 1310, die eine Driftzone ausbildet, eine P-Wanne 1320, die ein Bodyhalbleitergebiet ausbildet, ein n-dotiertes Sourcehalbleitergebiet 1420 und ein p-dotiertes Bodyanschlusshalbleitergebiet 1430 auf. Weiterhin weist der N-DMOS-Feldeffekttransistor 1000 ein Feld-Oxid 1300 und ein Gate-Oxid 1500 mit einer darauf angeordneten Gate-Elektrode 1200 aus Polysilizium auf.

Drainhalbleitergebiet 1410, Gate-Elektrode 1200, Sourcehalbleitergebiet 1420 und Bodyanschlusshalbleitergebiet 1430 sind mit jeweils einer Metallleiterbahn 1110, 1120, 1130 und 1140 leitend verbunden. In dem Ausführungsbeispiel der Fig. 9 ist der Substratbereich 110 über das Polysilizium 750, die Diffusionsbarriere 755, das Metall 760 und die Leiterbahn 1110 mit dem Drainhalbleitergebiet 1410 verbunden, so dass der Substratbereich 110 im Wesentlichen dasselbe Potential wie das Drainhalbleitergebiet 1410 aufweist. Der Wafer ist durch ein Bor-Phosphor-Silicat-Glas 1900 gegen äußere Einflüsse geschützt.

Alternativ zur Fig. 9 kann der Substratbereich 110 auch an ein anderes Bauelement zur Steuerung des Potentials des Substratbereichs 110 angeschlossen sein. Eine weitere Möglichkeit besteht darin, den Substratbereich 110 beispielsweise mittels eines Spannungsteilers beispielsweise aus zwei Kondensatoren an ein festes Potential anzuschließen.

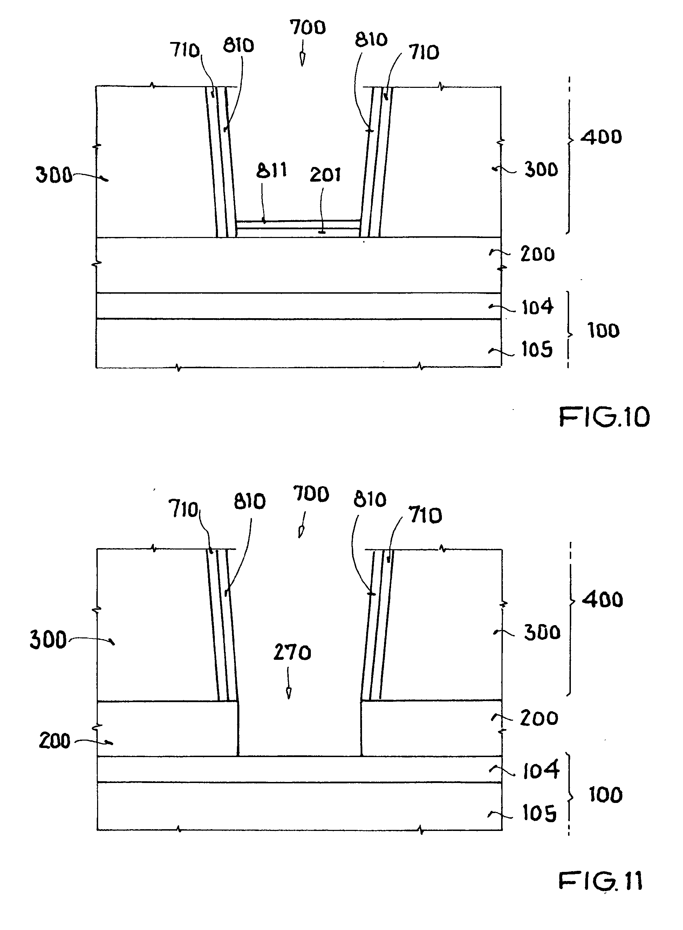

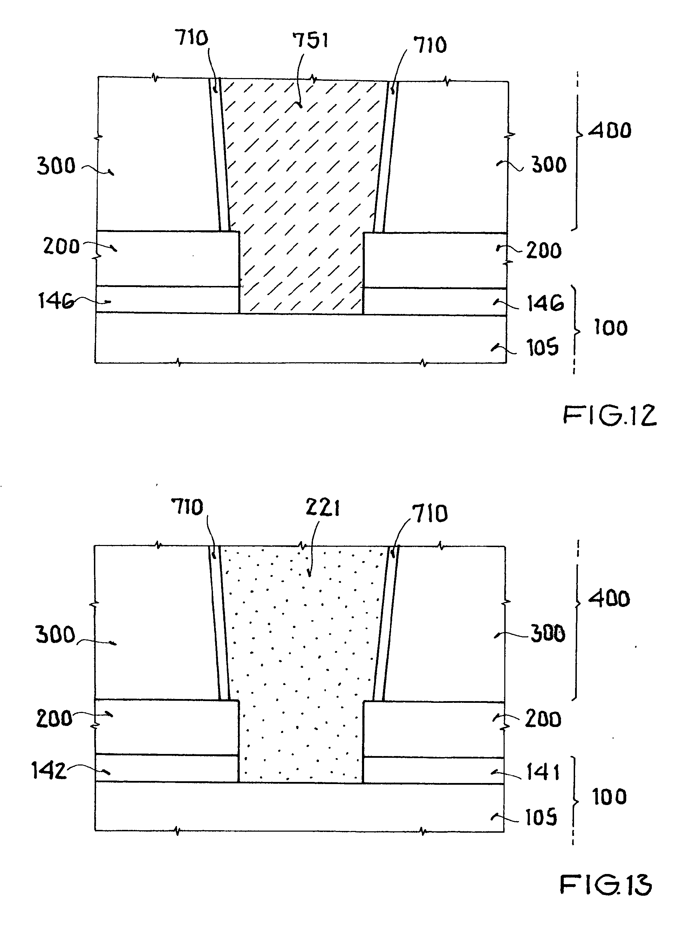

Ausgehend von dem in Fig. 4 dargestellten Prozesszustand zeigen die Figuren 10 und 11 ein weiteres Ausführungsbeispiel, in dem zunächst ein dünnes Oxid 201 abgeschieden wird. Danach wird auf dem Bodenbereich und auf den Wandbereichen 701 des Grabens 700 - der beispielsweise eine Breite von 0,8 µm aufweist - eine dünne Wandschicht 810 aus Siliziumnitrid (Si₃N₄) und auf dem Bodenbereich 702 des Grabens 700 eine dünne Bodenschicht 811 aus Siliziumnitrid (Si₃N₄) abgeschieden. Dieser Prozesszustand ist in Fig. 10 dargestellt.

Nachfolgend wird das dünne Oxid 201 und die dünne Bodenschicht 811 aus Siliziumnitrid (Si₃N₄) durch Ätzung entfernt. Danach wird der Graben 700 durch die vergrabene Isolatorschicht 200 bis zu einer leitfähigen Schicht 104 des Substrats 100 tiefgeätzt. Hierdurch wird in der vergrabenen Isolatorschicht 200 eine Öffnung 270 erzeugt, wobei in der Öffnung die leitfähige Schicht 104 im Graben 700 freigelegt wird.

Das Substrat 100 weist eine Dielektrikumschicht 105 und die leitfähige Schicht 104 auf, die auf die Dielektrikumschicht 105 aufgebracht ist. Die leitfähige Schicht 104 weist in den Ausführungsbeispielen der Figuren 10 und 11 bevorzugt dotiertes, polykristallines Silizium auf. Es können dabei auch andere leitfähige Materialien für die leitfähige Schicht 104 verwendet werden, bevorzugt ist das verwendete Material jedoch zur Ausbildung eines Dielektrikums oxidierbar. Weiterhin ist das leitfähige Material der leitfähigen Schicht vorzugsweise zum Bonden zweier Wafer geeignet.

Bevorzugt wird die SOI-Struktur mit dem Bauelementebereich 400, der vergrabenen Isolatorschicht 200 und dem Substrat 100 mit der leitfähigen Schicht 104 und der Dielektrikumschicht 105 hergestellt, indem ein erster das Substrat 100 bildender Wafer und ein zweiter Wafer hergestellt wird. Der erste Wafer kann beispielsweise durch konforme Abscheidung von dotiertem, polykristallinem Silizium auf einer dicken Dielektrikumschicht herstellt werden. Der zweite Wafer weist die Isolatorschicht 200 und den Bauelementebereich 400 auf. Danach wird der erste Wafer mit der Seite der leitfähigen Schicht 104 an die Seite der Isolatorschicht 200 des zweiten Wafers gebondet.

Alternativ zur Fig. 6 zeigt Fig. 12 eine Ausführungsvariante in der ein leitfähiger Substratbereich 146 durch einen Leiter 751 mit polykristallinem Silizium 751 kontaktiert wird. Hierzu wird polykristallines Silizium 751 im Prozesszustand der Fig. 11 in den Graben 700 eingebracht, wodurch eine leitende Verbindung zum leitfähigen Substratbereich 146 hergestellt wird. Anstelle des Polysiliziums 751 kann auch ein anderes leitfähiges Material, wie beispielsweise dotiertes amorphes Silizium oder ein Silizid verwendet werden.

Alternativ wird durch einen geätzten Trenngraben die leitfähige Schicht 104 in zwei leitfähige Substratbereiche 141 und 142 getrennt. Gemäß Fig. 13 wird dann der Graben 700 mit einem Dielektrikum 221 aus Siliziumdioxid (SiO₂) verfüllt. Das Dielektrikum gelangt dabei auch in einen Zwischenraum zwischen zwei Substratbereiche 142 und 141. Dadurch werden die zwei Substratbereiche 142 und 141 voneinander isoliert. Wird eine Grabenstruktur gemäß der Fig. 13 als geschlossene Struktur ausgebildet, kann beispielsweise der Substratbereich 142 durch die geschlossene Grabenstruktur lateral in alle Richtungen isoliert werden. Zur Kontaktierung dieses Substratbereiches 142 kann eine mit polykristallinem Silizium 751 verfüllte Grabenstruktur gemäß Fig. 12 verwendet werden, wobei in diesem Fall die Substratbereiche 142 und 146 identisch sind oder leitend aneinander grenzen. Vorteilhafterweise weist die leitfähige Schicht 104 zur Strukturierung eine Dicke auf, die 5 µm nicht überschreitet. Wird eine dickere leitfähige Schicht verwendet, können noch kleinere Widerstände in den Substratbereichen 142, 141 realisiert werden.

Dieses Ausführungsbeispiel ermöglicht, dass die Strukturierung der leitfähigen Substratbereiche 142 und 141 selbstjustiert zu dem tiefen Graben 700 ausgebildet wird. Eine Versetzung der beiden zueinander wird hierdurch vermieden. Wird der Graben zu einem Bauelement ausgerichtet, ist somit auch eine Ausrichtung des Substratbereiches 142, 141 zum Bauelement möglich.

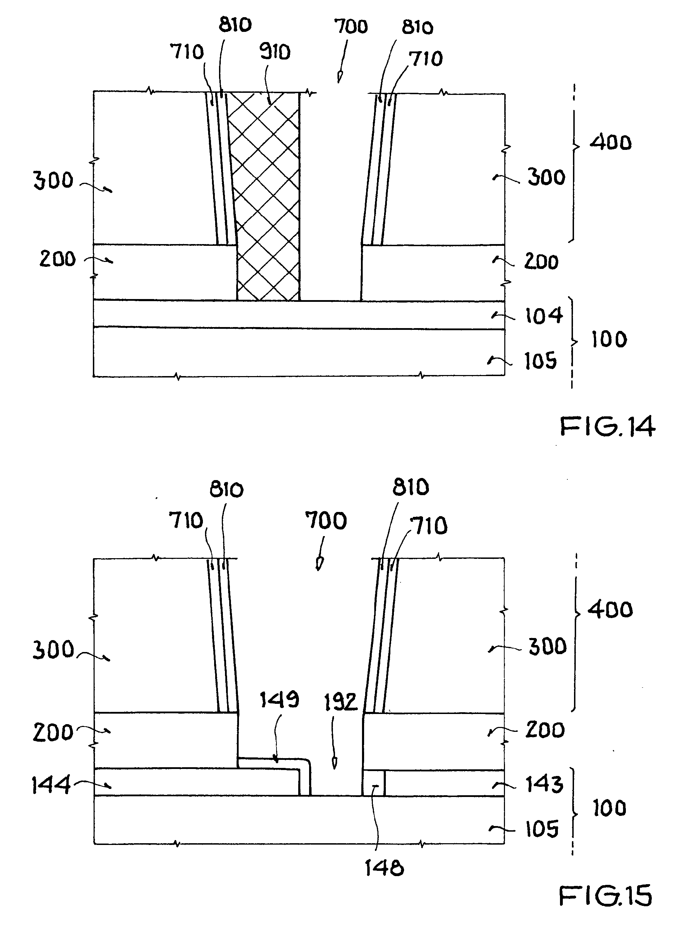

Die Figuren 14, 15 und 16 zeigen eine andere Ausführungsvariante zur Strukturierung einer leitfähigen Schicht 104 des Substrats 100 durch den Graben 700 und durch die Öffnung 270 in der vergrabenen Isolatorschicht 200 hindurch. Dabei wird zunächst ein Photolack aufgebracht und photolithographisch strukturiert. Der strukturierte Photolack 910 bildet eine Maskierung 910, die einen ersten Bereich der leitfähigen Schicht 104 innerhalb des Grabens 700 vor einem Ätzangriff schützt. Hingegen ist ein zweiter Bereich der leitfähigen Schicht 104 des Substrats 100 nicht durch den strukturierten Photolack 910 geschützt. Dieser Prozesszustand ist in Fig. 14 dargestellt.

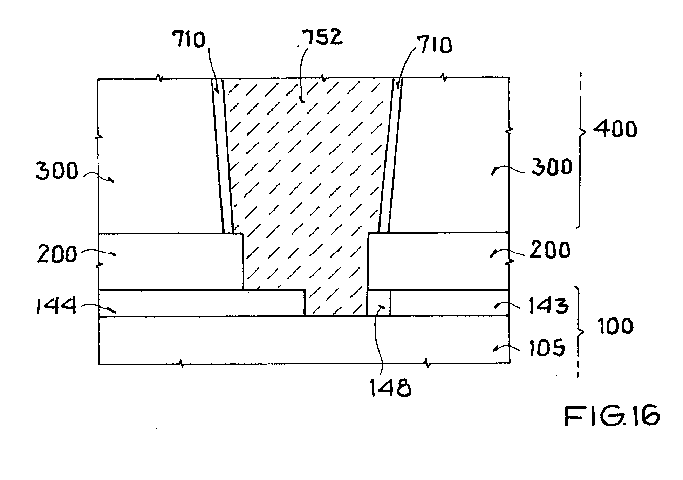

Im zweiten Bereich, der nicht von der Maskierung 910 geschützt ist, wird die leitfähige Schicht 104 durch eine Ätzung entfernt. Hierdurch entsteht ein Trenngraben 192, der einen Zwischenraum zwischen zwei leitfähigen Substratbereichen 144 und 143 bildet, wie dies in Fig. 15 dargestellt ist. Die freiliegenden Oberflächenbereiche der zwei leitfähigen Substratbereiche 144 und 143 aus polykristallinem Silizium werden durch eine thermische Oxidation zu einem ersten Siliziumdioxidbereich 148 und zu einem zweiten Siliziumdioxidbereich 149 gewandelt. Der erste Siliziumdioxidbereich 148 wächst an der Seitenwand des Grabens 700 zumindest teilweise unter die vergrabene Isolatorschicht 200. Der zweite Siliziumdioxidbereich 149 bedeckt den leitfähigen Substratbereich 144 innerhalb des Grabens 700. Dieser Prozesszustand ist in Fig. 15 dargestellt.

Nachfolgend wird die dünne Wandschicht 810 aus Siliziumnitrid (Si₃N₄) entfernt. Zudem wird mittels isotropen Plasmaätzens der zweite Siliziumdioxidbereich 149 entfernt. Zur Kontaktierung des leitfähigen Substratbereichs 144 wird in die Grabenstruktur ein Leiter 752 mit dotiertem, polykristallinem Silizium 752 eingebracht, wobei die Polysiliziumfüllung 752 an den leitfähigen Substratbereich 144 leitend grenzt. Dieser Prozesszustand ist in Fig. 16 dargestellt.

Durch dieses Ausführungsbeispiel der Fig. 16 ist die Erzielung einer besonders platzsparenden Ausbildung möglich, wobei in demselben Graben 700 sowohl eine Strukturierung einer leitfähigen Schicht 104 des Substrats 100 in mehrere leitfähige Substratbereiche 144 und 143 als auch eine Isolierung der Substratbereiche 143 und 144 voneinander durch ein Dielektrikum 148, als auch die Kontaktierung eines Substratbereiches 144 durch einen in den Graben 700 eingebrachten Leiter 752 synergetisch ausgebildet wird.

Bevorzugt werden die leitfähigen Substratbereiche als Elektroden für Leistungsbauelemente verwendet. Alternativ oder in Kombination hierzu kann ein leitfähiger Substratbereich auch als Widerstand oder Bestandteil einer Kapazität ausgebildet werden.

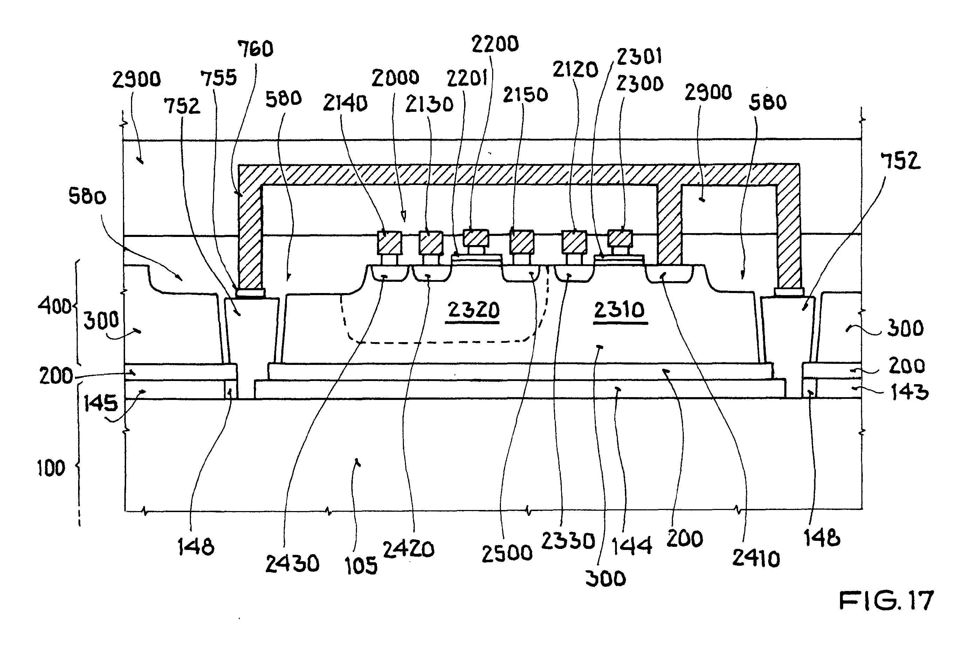

Auch kann ein Substratbereich als Teil einer Schirmung ausgebildet sein. Dies ist schematisch in Fig. 17 schematisch dargestellt. Die Halbleiteranordnung der Fig. 17 weist ein Substrat 100 mit drei dargestellten Substratbereichen 145, 144 und 143 auf. Die Substratbereiche 145, 144, 143 sind durch Dielektrika 148 von einander isoliert. Die Strukturierung der Substratbereiche 145, 144, 143 ist dabei entsprechend dem Ausführungsbeispiel der Figuren 14 bis 16 mittels Trenngräben erfolgt. In einen in den Bauelementebereich 400 geätzten tiefen Graben einer geschlossenen Struktur ist polykristallines Silizium 752 eingebracht. Dieses bildet zusammen mit dem Barrierematerial 755 und der Metallbahn 760 einen Leiter, der einen Schaltkreis 2000 von mehreren Seiten umfasst. Wird der Leiter an ein Potential angeschlossen, kann eine Schirmung des Schaltkreises 2000 realisiert werden. Dabei ist der Schaltkreis 2000 durch den Substratbereich 144 und den Leiter mit dem polykristallinen Silizium 752, der Barriere 755 und der Metallbahn 760 lateral und vertikal gegen Störstrahlung geschirmt.

Der Schaltkreis 2000 der Fig. 17 weist beispielsweise NMOS-Transistor mit einem P-Wanne 2320, einem p-Bodyanschlussgebiet 2430, einem Sourcegebiet 2420, einem Draingebiet 2500, einer Gateelektrode 2201, einem Bodymetallanschluss 2140, einem Sourcemetallanschluss 2130, einem Gatemetallanschluss 2200 und einem Drainmetallanschluss 2150. Der Schaltkreis 2000 weist weiterhin einen n-dotierten Bereich 2310 für einen PMOS-Transistor mit einem Sourcegebiet 2120, einem Draingebiet 2410, einer Gateelektrode 2301, einem Sourcemetallanschluss 2120, einem Gatemetallanschluss 2300 auf. Der Drainmetallanschluss ist mit der Metallbahn 760 des Leiters der Schirmung verbunden, so dass das Potential der Schirmung steuerbar ist.

Die Erfindung ist selbstverständlich nicht auf die dargestellten Ausführungsbeispiele beschränkt, sondern umfasst auch nicht dargestellte Ausführungsvarianten. Beispielsweise könnten der Substratbereich 144 auch lediglich einseitig kontaktiert werden. Auch ist es möglich eine einkristalline leitfähige Schicht 104 des Substrats 100 zu verwenden. Ebenfalls ist die Erfindung nicht auf die in den Figuren 9 und 17 dargestellten Bauelemente 1000 und Schaltkreise 2000 beschränkt, sondern schützt beispielsweise jede Halbleiteranordnung mit beliebigen Bauelementen, die von der Strukturierung einer vergrabenen leitfähigen Schicht eines SOI-Substrats innerhalb eines Grabens 700 gebrauch macht.

### Bezugszeichenliste

- 100: Substrat
- 101: Dielektrikum, Siliziumdioxid
- 102, 103: mit Dielektrikum verfüllter Trenngraben
- 104: polykristalline Siliziumschicht des Substrats
- 105: Dielektrikumschicht des Substrats
- 110, 120, 130, 141,: leitfähiger Substratbereich
- 142, 143, 144, 145,:
- 146:
- 148, 149: Dielektrikum, Siliziumdioxid
- 192: Trenngraben in der polykristallinen Siliziumschicht des Substrats
- 200: vergrabene Isolatorschicht, SiO₂
- 210: Siliziumdioxidschicht
- 220: mit Dielektrikum verfüllter tiefer Graben
- 221: Dielektrikum, Siliziumdioxid
- 270: Öffnung in der vergrabenen Isolatorschicht
- 300: monokristallines Siliziumkristall
- 400: Bauelementebereich
- 410: Bereich mit Kristallstörungen
- 510: erste Oxidschicht
- 520: Polysiliziumschicht
- 530: zweite Oxidschicht
- 550, 550': Oxidschicht
- 580, 580': Dielektrikum, Siliziumdioxid
- 600: flacher, geätzter Graben
- 700: tiefer Graben, geätzt
- 701: Wandung des tiefen Grabens
- 702: Boden des tiefen Grabens
- 710: Isoliermaterial, Siliziumdioxid
- 720: Isoliermaterial, Siliziumdioxid
- 750, 751, 752: dotierte Polysiliziumfüllung
- 755: Diffusionsbarriere, Silizid
- 760: Metall, Wolfram, Aluminium
- 800, 810, 811: Hartmaske, Si₃N₄
- 900, 910: Resist, Photolackmaskierung
- 1000: Bauelement, N-DMOS-Feldeffekttransistor
- 1110, 1120,: Metallisierung, Leiterbahn
- 1130, 1140, 2140,:
- 2130, 2200, 2150,:
- 2120, 2300:
- 1200, 2201, 2301: Gate-Elektrode, polykristallines Silizium
- 1300: Feld-Oxid
- 1310, 2310: N-Wanne, Driftzone
- 1320, 2320: P-Wanne, Body
- 1410, 2500, 2410: Drainhalbleitergebiet
- 1420, 2420, 2330: Sourcehalbleitergebiet
- 1430, 2430: Bodyanschlusshalbleitergebiet
- 1500: Gate-Oxid
- 1900, 2900: Bor-Phosphor-Silicat-Glas
- B: Dotierstoff (Bor) einer Implantation

## Patentansprüche

1. Verfahren zur Herstellung einer Halbleiteranordnung, bei dem
- ein leitfähiges Substrat (100), ein Bauelementebereich (400) und eine den Bauelementebereich (400) von dem leitfähigen Substrat (100) isolierende Isolatorschicht (200) ausgebildet wird,
- ein Graben (700) in den Bauelementebereich (400) bis zur Isolatorschicht (200) geätzt wird,
- der Graben (700) weiter in die Isolatorschicht (200) bis zum leitfähigen Substrat (100) geätzt wird, und
- das leitfähige Substrat (100) zur Ausbildung von voneinander isolierten leitfähigen Substratbereichen (141, 142, 143, 144, 145, 146) teilweise geätzt wird.

2. Verfahren nach Anspruch 1, bei dem das leitfähige Substrat (100) zur Ausbildung von voneinander isolierten leitfähigen Substratbereichen (141, 142, 143, 144, 145, 146) zumindest teilweise innerhalb des Grabens (700) geätzt wird.

3. Verfahren nach Anspruch 2, bei dem zur Ausbildung der Isolierung (148) der Substratbereiche (143, 144, 145) eine leitfähige Schicht (104) des Substrats (100) durch die Ätzung strukturiert und ein offen liegender Bereich der leitfähigen Schicht (104) zur Ausbildung eines isolierenden Dielektrikums (148) thermisch oxidiert wird.

4. Verfahren nach Anspruch 3,
- bei dem zur Strukturierung eine Maskierung (910) ausgebildet wird, die einen ersten Bereich der leitfähigen Schicht (104) innerhalb des Grabens (700) vor dem Ätzangriff schützt, und
- bei dem ein zweiter, nicht von der Maskierung (910) geschützter Bereich der leitfähigen Schicht (104) durch die Ätzung entfernt wird.

5. Verfahren nach Anspruch 1,
- bei dem zur Ausbildung der Isolierung (148) der Substratbereiche (141, 142) eine leitfähige Schicht (104) des Substrats (100) innerhalb des Grabens (700) zumindest teilweise durch die Ätzung entfernt wird, und
- bei dem innerhalb des Grabens (700) zwischen den ausgebildeten Substratbereichen (141, 142) ein Dielektrikum (221) abgeschieden wird.

6. Verfahren nach einem der vorhergehenden Ansprüche, bei dem ein elektrischer Leiter (751, 752, 755, 760) in den Graben (700) oder einen weiteren Graben eingebracht und mit einem Substratbereich (144, 146) der voneinander isolierten Substratbereiche (141, 142, 143, 144, 145, 146) leitend verbunden wird.

7. Verfahren nach einem der vorhergehenden Ansprüche, bei dem das Substrat (100) mit einer Dielektrikumschicht (105) und mit einer leitfähigen Schicht (104) ausgebildet wird.

8. Verfahren nach einem der vorhergehenden Ansprüche,
- bei dem eine flache Vertiefung (600) in einer Oberfläche des Bauelementebereiches (400) geätzt wird,
- bei dem innerhalb der flachen Vertiefung (600) der Graben (700) in den Bauelementebereich (400) geätzt wird, und
- bei dem die Wände (701) des Grabens (700) mit einem Isolationsmaterial (710) ausgebildet werden.

9. Verfahren nach Anspruch 8,
- bei dem die flache Vertiefung (600) mit Dielektrikum (580') gefüllt wird, und
- bei dem ein Dotierstoff (B) für ein Halbleitergebiet (1430) des zumindest einen Bauelementes (1000) eingebracht wird,
- wobei das Dielektrikum (580') in der flachen Vertiefung (600) als Maskierung dient, um das Halbleitergebiet (1430) des zumindest einen Bauelementes (1000) selbstjustiert zur Vertiefung (600) in dem Bauelementebereich (400) auszubilden.

10. Verfahren nach einem der Ansprüche 8 oder 9, bei dem zur Ausbildung des Isolationsmaterials (710) ein an den Graben (700) angrenzender Siliziumbereich des Bauelementebereichs (400) oxidiert wird.

11. Verfahren nach einem der vorhergehenden Ansprüche,
- bei dem das leitfähige Substrat (100) zur Ausbildung von voneinander isolierten leitfähigen Substratbereichen (110, 120, 130) von der dem Graben (700) abgewandten Substratseite aus geätzt wird,
- bei dem Wände (701) des Grabens (700) mit einem Isolationsmaterial (710) ausgebildet werden, und
- bei dem ein elektrischer Leiter (750, 755, 760) in den Graben (700) eingebracht und mit zumindest einem Substratbereich (110) der leitfähigen Substratbereiche (110, 120, 130) leitend verbunden wird.

12. Halbleiteranordnung,
- mit einem Bauelementebereich (400),
- mit einem leitfähigen Substrat (100),
- mit einer vergrabenen Isolatorschicht (200), die den Bauelementebereich (400) gegenüber dem leitfähigen Substrat (100) isoliert,
- mit zumindest einem, mit einem Isolationsmaterial (710) gefüllten Graben (700), der zumindest ein Bauelement (1000, 2000) im Bauelementebereich (400) von weiteren Bauelementen im Bauelementebereich (400) isoliert,
- mit einem elektrischen Leiter (750, 751, 752, 755, 760), der mit dem leitfähigen Substrat (100) leitend verbunden ist,
- bei der der elektrische Leiter (750, 751, 752, 755, 760) durch das Isolationsmaterial (710) isoliert in dem Graben (700) angeordnet ist, und
- bei der das leitfähige Substrat (100) Substratbereiche (110, 120, 130, 141, 142, 143, 144, 145, 146) aufweist, die durch eine Anzahl geätzter Gräben (102, 103, 192) unterteilt sind,
- wobei die Gräben mit einem Dielektrikum (101, 148, 221) zur Isolierung gefüllt sind.

13. Halbleiteranordnung nach Anspruch 12, bei dem mehrere voneinander isolierte Substratbereiche (110, 120, 130, 141, 142, 143, 144, 145, 146) jeweils mit zumindest einem in je einem Graben (700) angeordneten Leiter (750, 751, 752, 755, 760) leitend verbunden sind.

14. Halbleiteranordnung nach einem der vorhergehenden Ansprüche, bei dem zumindest einer der Substratbereiche (110, 144) unterhalb des Bauelementes (1000) ausgebildet ist, und bei dem das Bauelement ein lateraler DMOS-Feldeffekttransistor (1000) ist.

15. Halbleiteranordnung nach einem der vorhergehenden Ansprüche, bei dem ein Leiter (752, 755, 760) und ein Substratbereich (144) der Substratbereiche (143, 144, 145) das zumindest eine Bauelement (1000, 2000) zumindest teilweise umgeben und zusammen als Schirmung ausgebildet sind.

16. Halbleiteranordnung nach einem der vorhergehenden Ansprüche, bei dem innerhalb des Grabens (700) ein Dielektrikum (148) zur Isolation der Substratbereiche (143, 144, 145) voneinander angeordnet ist.

17. Halbleiteranordnung nach einem der vorhergehenden Ansprüche, bei dem der Graben (700) innerhalb einer Vertiefung (600) in einer Oberfläche ausgebildet ist.

18. Halbleiteranordnung nach einem der vorhergehenden Ansprüche, bei der ein Halbleitergebiet (1430) des zumindest einen Bauelementes (1000) selbstjustiert zur Vertiefung (600) in dem Bauelementebereich (400) ausgebildet ist.

19. Schaltkreis mit einer Halbleiteranordnung nach einem der vorhergehenden Ansprüche, der Mittel aufweist an dem elektrischen Leiter (750, 751, 752, 755, 760) ein konstantes oder steuerbares Potential anzulegen, wobei von dem konstanten oder steuerbaren Potential zumindest eine elektrische Eigenschaft des zumindest einen Bauelementes (1000, 2000) abhängig ist.

20. Verwendung eines leitfähigen Substratbereiches (144) und eines mit dem Substratbereich (144) leitend verbundenen Leiters (752, 755, 760) zur mehrseitigen Schirmung eines Bauelementes (1000, 2000), das oberhalb des leitfähigen Substratbereichs (144) angeordnet und von dem Substratbereich (144) dielektrisch isoliert ist.
